# EUROPEAN PATENT SPECIFICATION

(11) **EP 2 520 941 B1**
(45) Date of publication and mention of the grant of the patent: **04.03.2015**
(21) Application number: 11163836.7
(22) Date of filing: 27.04.2011
(51) Int. Cl.: G01R 13/02, G01R 13/34

(54) **Trigger figure-of-merit indicator**
Auslöserleistungszahlanzeige
Indicateur de déclenchement de facteur de mérite

(43) Date of publication of application: 07.11.2012
(73) Proprietor: Tektronix, Inc., Beaverton, Oregon 97077-0001 (US)
(72) Inventor: Turpin, John F., Tigard, OR 97223 (US)
(74) Representative: Clarke, Jeffrey David

(56) References cited:
- EP-A1- 2 048 509
- US-A- 4 642 519
- US-A- 4 779 028
- US-A1- 2006 129 355
- US-A1- 2010 231 398
- US-B1- 6 714 883

## Description

### FIELD OF THE INVENTION

The present invention relates to test and measurement instruments, and more particularly to tools that make it easier for a user to set up and arm a trigger event detector.

### BACKGROUND OF THE INVENTION

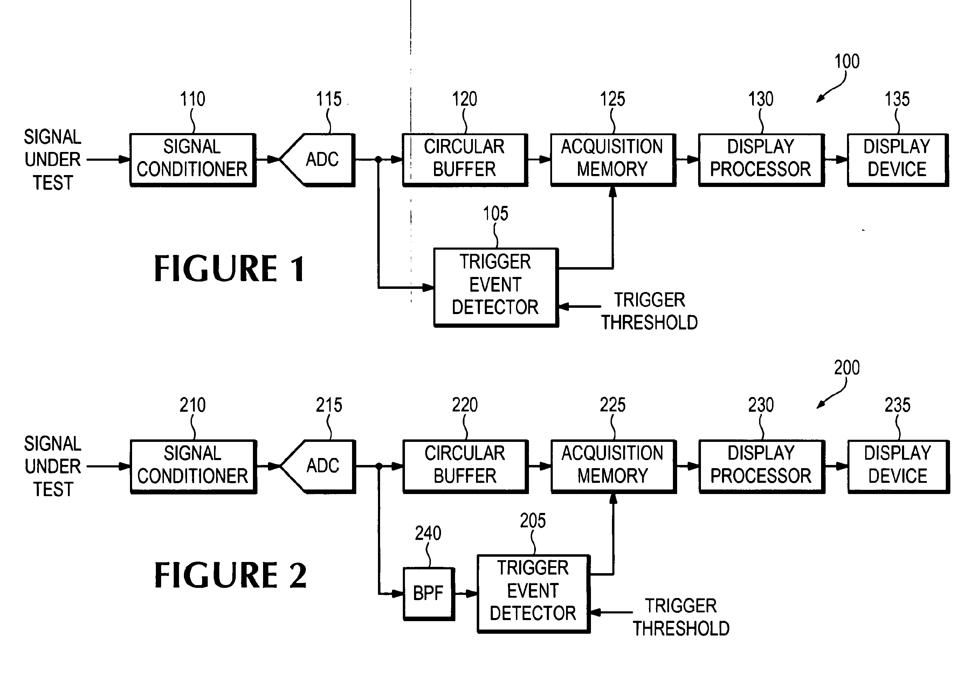

Test and measurement instruments such as spectrum analyzers, oscilloscopes, and logic analyzers have "trigger event detectors" that allow them to capture and analyze portions of a signal-under-test before, at, and after specific events occur referred to as "trigger events." Trigger events can be detected from the signal-under-test itself or from a secondary signal. In order to insure a high probability of detecting a trigger event, a trigger event detector must operate continuously, regardless of whether a trigger event is present or not. Figure 1 illustrates a spectrum analyzer **100** having such a trigger event detector **105**. In operation, a signal-under-test is conditioned by a signal conditioner **110** (e.g., by down-converting the signal-under-test from RF to IF) and then digitized by an analog-to-digital converter (ADC) **115** to produce a continuous stream of digitized samples. The digitized samples are written into a circular buffer **120** and also input to the trigger event detector **105**. The trigger event detector **105** processes the digital samples and then compares the processed samples to a user-specified trigger threshold. When the processed digital samples exceed the trigger threshold, the trigger event generator **105** generates a trigger signal that causes an acquisition memory **125** to capture the digitized samples that are held in the circular buffer **120**. The captured samples are then analyzed by a display processor **130** (e.g., by transforming them into the frequency domain using a frequency transform such as a fast Fourier transform (FFT), a chirp-Z transform, or the like) and displayed on a display device **135**. The trigger event detector **105** may be any one of various kinds of trigger event detectors that are used to detect various kinds of trigger events. For example, the trigger event detector **105** may be a "power level trigger" that detects when the instantaneous power of the signal-under-test exceeds a user-specified power threshold. In that case, the trigger event detector **105** processes the digitized samples by converting them into a measure of the instantaneous power of the signal-under-test, and the user-specified trigger threshold is a power threshold. When the instantaneous power of the signal-under-test exceeds the power threshold, the trigger event generator **105** generates the trigger signal.

In order to detect more complex trigger events, a trigger event detector may need to be more selective than the acquisition path of the instrument (i.e., the signal conditioner, ADC, circular buffer, acquisition memory, and so on). For example, as shown in Figure 2, a spectrum analyzer **200** may include a band-pass filter (BPF) **240** that filters the signal-under-test before it is applied to the trigger event detector **205** so that the trigger event detector **205** only detects trigger events within a narrow range of frequencies (as described in U.S. Patent No. 5,493,209 titled "Tunable trigger acquisition system and method for making in-service time-domain signal measurements"). In this manner, the bandwidth of the signal received by the trigger event detector **205** is much narrower than the bandwidth of the signal-under-test displayed on the display device **235**.

The deficiency in these conventional instruments is that it is difficult for a user to ascertain how to set up and arm the trigger event detector. That is, the user cannot see the signal-under-test on the display device until a trigger event occurs. Thus, if the trigger event detector is set up improperly or if the signal-under-test changes after the user arms the trigger event detector, then the user has no way of ascertaining why the instrument is not triggering. This deficiency is particularly problematic in the case where the trigger event detector is more selective than the acquisition path of the instrument because, even if the user can somehow get the instrument to display the signal-under-test (e.g., by forcing a trigger), the signal-under-test shown on the display device does not necessarily correspond to the signal received by the trigger event detector.

US 4,642,519 discloses a digital wave observation apparatus having an A/D converter for converting an input signal, a trigger level setting device for setting a trigger level, a trigger signal generator for comparing the input signal with a set trigger level and thereby generating a trigger signal, a wave memory for storing an A/D converted input signal in response to the trigger signal and a display for displaying the stored input signal comprising a trigger level display device for displaying a horizontal line corresponding to a trigger level on the display irrespective of the generation of the trigger signal.

EP 2 048 509 discloses a test and measurement instrument comprising a modulation signature trigger for comparing an input signal against a modulation signature, such as a magnitude signature or a phase signature. A detector compares the magnitude values or phase values against a corresponding modulation signature. When a match is indicated a trigger signal or other indication is produced. In some embodiments the signal under test may be captured or acquired based upon the trigger signal. In other embodiments a marker may be associated with stored signal data when a match is indicated.

US 4,779,028 discloses a digital storage oscilloscope comprising an A/D converter for receiving an analog input signal and generating a succession of data words representative of instantaneous magnitudes of the analog signal at equally spaced time intervals. A waveform memory has a plurality of separately addressable storage locations for storing the succession of data words at locations of which the addresses are related to the respective sample times. A trigger circuit compares the instantaneous magnitude of the analog input signal with a predetermined trigger level and generates a trigger pulse when the instantaneous magnitude of the input signal bears a predetermined relationship to the trigger level. The trigger circuit also causes an address word to be stored that defines the storage location for the first data word that occurs after the trigger pulse. The stored address word and the data word stored at the location defined by the stored address word are used to cause a visually distinct marker to be generated on the screen of the oscilloscope at a location that represents the time of occurrence of the trigger pulse.

US 6,714,883 discloses a system and method for use in signal measurement systems that acquire and store signal data in accordance with a trigger specification. Operator-generated annotations are stored and displayed with each trigger branch of a trigger specification. The annotations can provide meaningful information about, for example, the trigger branch condition, occurrence specification or resulting action, as well as any other aspect of the trigger specification. The branch comments are stored with the associated trigger branch as part of the instrument configuration, and are automatically restored when the configuration data is loaded into the instrument, and printed with the associated trigger branch. The display of the trigger branch comments for each trigger branch may be controlled individually or collectively to enable the operator to configure the display of the trigger specification as needed. The trigger branch comments may be provided through the use of a text editor, programmatically or through a file or data transfer. Advantageously, the operator can annotate the trigger sequence levels and branches as they are developed to facilitate insight, understanding and recollection for the same and other operators. Providing the annotations facilitates the use of previously generated and stored trigger specifications to form a new, more complex trigger specification.

### SUMMARY OF THE INVENTION

What is needed is a way for a user to easily ascertain how close a signal-under-test is to satisfying a relevant trigger condition.

Accordingly, there is provided a test and measurement instrument as set out in claim 1. Embodiments of the present invention provide a real-time trigger figure-of-merit indicator for test and measurement instruments that provides an indication of how close a signal-under-test is to satisfying a relevant trigger condition. The indicator includes a first marker that indicates a real-time trigger figure-of-merit that is calculated based on digital samples that represent the signal-under-test, and a second marker that indicates a level that the figure-of-merit must exceed in order for a trigger event detector to detect a trigger event and generate a trigger signal. Thus, by observing the indicator, a user may easily ascertain how close a signal-under-test is to satisfying the relevant trigger condition without requiring the instrument to actually trigger.

The objects, advantages and other novel features of the present invention are apparent from the following detailed description when read in conjunction with the appended claims and attached drawing.

### BRIEF DESCRIPTION OF THE DRAWINGS

Figure 1 depicts a high-level block diagram of a conventional spectrum analyzer having a power level trigger.
Figure 2 depicts a high-level block diagram of a conventional spectrum analyzer having a filtered power level trigger.
Figure 3 depicts a high-level block diagram of a spectrum analyzer having a real-time trigger figure-of-merit indicator according to an embodiment of the present invention.
Figure 4 depicts a more detailed view of the real-time trigger figure-of-merit indicator shown in Figure 3.

### DETAILED DESCRIPTION OF THE INVENTION

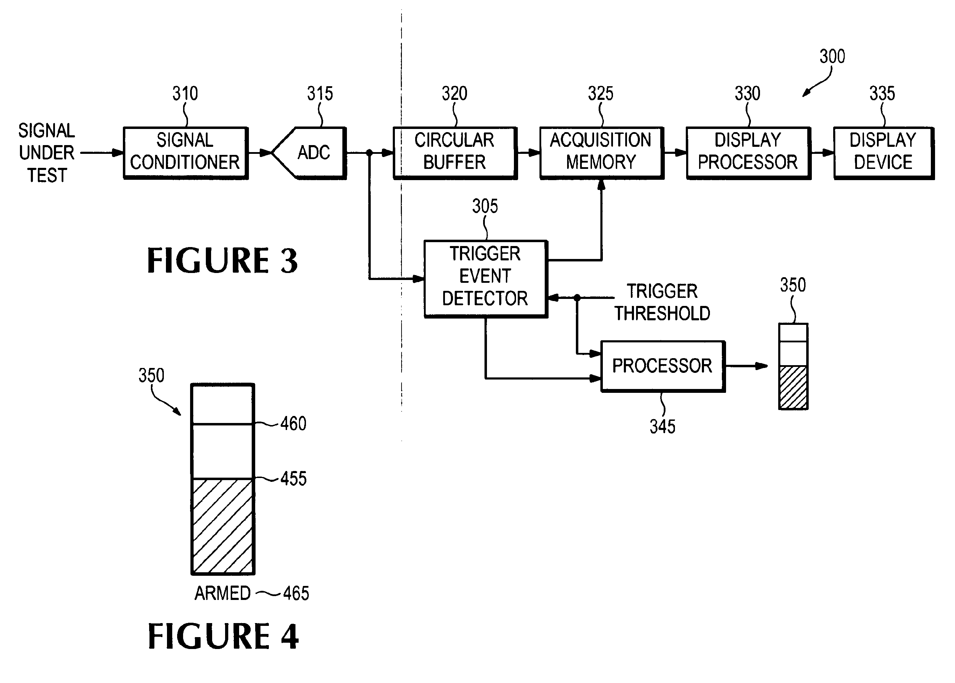

Referring now to Figure 3, a spectrum analyzer **300** according to an embodiment of the present invention is similar to the spectrum analyzer **100** shown in Figure 1 but also includes a processor **345** that receives a copy of the processed digital samples from the trigger event detector **305** and a copy of the user-specified trigger threshold, and generates based on them a real-time trigger figure-of-merit indicator **350** that indicates how close the signal-under-test is to satisfying a relevant trigger condition. Referring now to Figure 4, the indicator **350** includes a first marker **455** that indicates a real-time trigger "figure-of-merit" that is calculated based on the processed digital samples. For example, if the trigger event detector **305** is a power level trigger, then the figure-of-merit is the instantaneous power of the signal-under-test. Similarly, if the trigger event detector **305** is a filtered power level trigger, then the figure-of-merit is the instantaneous power of the filtered signal-under-test. The indicator **350** also includes a second marker **460** that indicates a level that the figure-of-merit must exceed in order for the trigger event detector **305** to detect a trigger event and generate a trigger signal. For example, if the trigger event detector **305** is a power level trigger or filtered power level trigger, then the marker **460** indicates the user-specified power threshold. Optionally, the indicator **350** may also include a third marker **465** that indicates the state of the trigger event detector **305**, i.e., "armed", "ready", "triggered," and so on. The indicator **350** may be displayed on the display device **335,** on a front-panel of the instrument (not shown), or in cases where the instrument is controlled by a remote computer (not shown), the indicator **350** may be displayed on a display device of that computer. Thus, by simply observing the indicator 350, a user may easily ascertain how close the signal-under-test is to satisfying a relevant trigger condition. This is particularly advantageous for instruments in which the trigger event detector is more selective than the acquisition path of the instrument.

The real-time trigger figure-of-merit is not only useful when used in conjunction with a power level trigger and a filtered power level trigger, but in various other embodiments may be adapted to be used with any type of trigger event detector. For example:

In another embodiment, the trigger event detector **305** is a "frequency mask trigger" as described in U.S. Patent No. 5,103,402 titled "Method and apparatus for identifying, saving, and analyzing continuous frequency domain data in a spectrum analyzer" which transforms the digitized samples of the signal-under-test into a continuous series of frequency spectra and generates a trigger signal when a frequency spectrum violates a user-defined frequency mask. In that case, the processed digital samples are the frequency spectra and the user-specified trigger threshold is the frequency mask. The marker **455** indicates the value of the spectrum that is closest to the frequency mask, and the marker **460** indicates the corresponding value of the frequency mask.

In another embodiment, the trigger event detector **305** is a "density trigger" as described in EP 2228660 titled "Frequency Domain Bitmap Triggering Using Color, Density and Correlation Based Triggers" which generates a trigger signal when the sample density within a user-defined density marker box exceeds a user-specified density threshold. In that case, the processed digital samples are the instantaneous density within the density marker box and the user-specified trigger threshold is the density threshold. The marker **455** indicates the instantaneous value of the density, and the marker **460** indicates the density threshold.

In another embodiment, the trigger event detector **305** is an "external trigger" which generates a trigger signal when the voltage sensed at an external trigger input connector (not shown) exceeds a user-specified voltage threshold. In this case, the processor **345** does not receive the processed digital samples from the trigger event detector **305,** but rather receives the voltage sensed at the external trigger input connector, and the user-specified trigger threshold is the voltage threshold. The marker **455** indicates the instantaneous voltage sensed at the external trigger input connector, and the marker **460** indicates the voltage threshold.

In another embodiment, the trigger event detector **305** is a "modulation domain trigger" as described in EP 1669764 titled "Modulation domain trigger" which transforms the digitized samples of the signal-under-test into the modulation domain and generates a trigger signal when an anomaly is detected. In that case, the figure-of-merit may be any one of various signal quality measurements such as error vector magnitude (EVM), phase error, magnitude error, in-phase/quadrature (I/Q) imbalance, skew, origin offset, number of bits per second, packets per second, and so on. In general, any quantifiable aspect of the signal may be used as a figure-of-merit.

It will be appreciated that the list of trigger event detectors described above is not an exhaustive list, and that a real-time trigger figure-of-merit indicator may be used in conjunction with any kind of trigger event detector now existing or yet to be developed without departing from the scope of the invention as defined in the claims. That is, regardless of the particular trigger condition that a trigger event detector uses, a real-time trigger figure-of-merit indicator can be used to provide a real-time indication of how close a signal-under-test is to satisfying that trigger condition. For example, if a trigger event detector generates a trigger signal when an aspect of a signal-under-test "matches" a specified condition (such as a specified data pattern, a specified spectral signature, or the like), then the real-time trigger figure-of-merit indicator may indicate "nearness of match," "degree-of-match," or the like. Furthermore, some types of trigger event detectors may have more than one figure-of-merit. Multiple indicators may be used with those types of trigger event detectors, one for each figure-of-merit.

Although the real-time trigger figure-of-merit indicator was described above as being used in conjunction with a spectrum analyzer, it will be appreciated that in various other embodiments a real-time trigger figure-of-merit indicator may be used in conjunction with any other kind of test and measurement instrument that uses a trigger event detector such as an oscilloscope or a logic analyzer.

Although the real-time trigger figure-of-merit indicator was depicted in the Figures as a vertical bar, it will be appreciated that in other embodiments the indicator may have a different visual appearance, e.g., it may be a horizontal bar, a dial, and so on.

In various embodiments, the processor **345** may be implemented in hardware, software, or a combination of the two, and may comprise a general purpose microprocessor, a digital signal processor (DSP), an application specific integrated circuit (ASIC), a field-programmable gate array (FPGA), or the like.

It will be appreciated from the foregoing discussion that the present invention represents a significant advance in the field of triggers for test and measurement instruments.

## Claims

1. A test and measurement instrument (300) comprising:
a circular buffer (320) configured to receive and hold digitized samples of a signal under test;
a trigger event detector (305) configured to also receive and process the digitized samples and a user-specified trigger threshold, to detect a trigger event based on the processed digitized samples and the user-specified trigger threshold, and to generate a trigger signal;
an acquisition memory (325) configured to receive the trigger signal and capture a portion of the digitized samples that are held in the circular buffer (320) in response to the trigger signal;
the test and measurement instrument (300) **characterized by** further comprising:
a processor (345) configured to receive a copy of the processed digitized samples from the trigger event detector (305) and the user-specified trigger threshold, so as to generate a real-time trigger figure-of-merit indicator (350) which includes:
a first marker (455) that indicates a real-time trigger figure-of-merit that is calculated based on the processed digitized samples, wherein the real-time trigger figure-of-merit is a quantifiable aspect of the signal under test; and
a second marker (460), based on the user-specified trigger threshold, that indicates a level that the real-time trigger figure-of-merit must exceed in order for the trigger event detector (305) to detect a trigger event and to generate the trigger signal; and
display means configured to display the real-time trigger figure-of-merit indicator (350);
wherein the real-time trigger figure-of-merit indicator (350) provides a continuous indication of how close the signal under test is to satisfying the user-specified trigger threshold without requiring the instrument to actually trigger.

2. A test and measurement instrument (300) as in claim 1, wherein the real-time trigger fgure-of merit indicator (350) further comprises a third marker (465) that indicates a state of the trigger event detector (305).

3. A test and measurement instrument (300) as in claim 1, wherein the trigger event detector (305) is selected from the group consisting of a power level trigger, a filtered power level trigger, a frequency mask trigger, a density trigger, a modulation domain trigger, an external trigger, a data pattern trigger, and a spectral signature trigger.

4. A test and measurement instrument (300) as in claim 1, wherein the test and measurement instrument is a test and measurement instrument selected from the group consisting of a spectrum analyzer, an oscilloscope, and a logic analyzer.

5. A test and measurement instrument (300) as in claim 1, wherein the real-time trigger figure-of-merit indicator is displayed on the display means (335) selected from the group consisting of a display device and a front-panel.

6. A test and measurement instrument (300) as in claim 1, wherein the real-time trigger figure-of-merit is any one of:
an instantaneous power of the signal under test;
an instantaneous power of a filtered signal under test;
a signal quality measurement such as error vector magnitude (EVM), phase error, magnitude error, in-phase/quadrature (I/Q) imbalance, skew, origin offset, number of bits per second, or packets per second.

## Patentansprüche

1. Prüf- und Messinstrument (300), umfassend:
einen Ringspeicher (320), der so ausgelegt ist, dass er digitalisierte Abtastwerte eines zu prüfenden Signals empfängt und speichert;
einen Auslöseereignisdetektor (305), der so ausgelegt ist, dass er die digitalisierten Abtastwerte und einen benutzerdefinierten Auslöseschwellenwert ebenfalls empfängt und diese verarbeitet, um ein Auslöseereignis auf Grundlage der verarbeiteten digitalisierten Abtastwerte und des benutzerdefinierten Auslöseschwellenwerts zu detektieren und ein Auslösesignal zu erzeugen;
einen Erfassungsspeicher (325), der so ausgelegt ist, dass er das Auslösesignal empfängt und einen Teil der digitalisierten Abtastwerte, die in dem Ringspeicher (320) gespeichert sind, in Reaktion auf das Auslösesignal erfasst;
wobei das Prüf- und Messinstrument (300) **dadurch gekennzeichnet ist, dass** es ferner Folgendes umfasst:
einen Prozessor (345), der so ausgelegt ist, dass er eine Kopie der verarbeiteten digitalisierten Abtastwerte von dem Auslöseereignisdetektor (305) und des benutzerdefinierten Auslöseschwellenwerts empfängt, um eine Echtzeitanzeige für eine Auslösegütezahl (350) zu erzeugen, die Folgendes umfasst:
eine erste Markierung (455), die eine Echtzeit-Auslösegütezahl angibt, die auf Grundlage der verarbeiteten digitalisierten Abtastwerte berechnet wird, wobei es sich bei der Echtzeit-Auslösegütezahl um einen quantifizierbaren Aspekt des zu prüfenden Signals handelt; und
eine zweite Markierung (460), die auf dem benutzerdefinierten Auslöseschwellenwert basiert und ein Maß angibt, das die Echtzeit-Auslösegütezahl überschreiten muss, damit der Auslöseereignisdetektor (305) ein Auslöseereignis feststellt und das Auslösesignal erzeugt; und
Anzeigemittel, die so ausgelegt sind, dass sie die Echtzeitanzeige für eine Auslösegütezahl (350) anzeigen;
wobei die Echtzeitanzeige für eine Auslösegütezahl (350) eine kontinuierliche Anzeige davon bereitgestellt, wie nahe das zu prüfende Signal daran ist, den benutzerdefinierten Auslöseschwellenwert zu erfüllen, ohne dass das Instrument tatsächlich auslösen muss.

2. Prüf- und Messinstrument (300) nach Anspruch 1, wobei die Echtzeitanzeige für eine Auslösegütezahl (350) ferner eine dritte Markierung (465) umfasst, die einen Zustand des Auslöseereignisdetektors (305) angibt.

3. Prüf- und Messinstrument (300) nach Anspruch 1, wobei der Auslöseereignisdetektor (305) ausgewählt ist aus der Gruppe bestehend aus einem Leistungspegel-Auslöser, einem gefilterten Leistungspegel-Auslöser, einem Frequenzmasken-Auslöser, einem Dichte-Auslöser, einem Modulationsdomänen-Auslöser, einem externen Auslöser, einem Datenmuster-Auslöser und einem Spektralsignatur-Auslöser.

4. Prüf- und Messinstrument (300) nach Anspruch 1, wobei es sich bei dem Prüf- und Messinstrument um ein Prüf- und Messinstrument handelt, das ausgewählt ist aus der Gruppe bestehend aus einem Spektralanalysator, einem Oszilloskop und einem Logikanalysator.

5. Prüf- und Messinstrument (300) nach Anspruch 1, wobei die Echtzeitanzeige für eine Auslösegütezahl auf den Anzeigemitteln (335) angezeigt wird, die ausgewählt sind aus der Gruppe bestehend aus einer Anzeigevorrichtung und einem Bedienfeld.

6. Prüf- und Messinstrument (300) nach Anspruch 1, wobei es sich bei der Echtzeit-Auslösegütezahl um eines der Folgenden handelt:
eine Momentanleistung des zu prüfenden Signals;
eine Momentanleistung eines gefilterten zu prüfenden Signals;
ein Maß für die Signalqualität, wie z. B. Fehlervektorgröße (*Error Vector Magnitude,* EVM), Phasenfehler, Amplitudenfehler, In-Phase/Quadrature- (I/Q-) Ungleichgewicht, Bitversatz (Skew), Nullpunktverschiebung, Anzahl der Bits pro Sekunde oder Pakete pro Sekunde.

## Revendications

1. Un instrument d'essai et de mesure (300) comprenant :
Une mémoire tampon circulaire (320) configurée pour recevoir et maintenir des échantillons numérisés d'un signal en cours d'essai ;
un détecteur d'événement déclencheur (305), configuré lui aussi pour recevoir et traiter les échantillons numérisés et un seuil de déclenchement spécifié par l'utilisateur, afin de détecter un événement déclencheur sur la base des échantillons numérisés traités et du seuil de déclenchement spécifié par l'utilisateur, et de produire un signal déclencheur ;
une mémoire de saisie (325) configurée pour recevoir le signal déclencheur et saisir une portion des échantillons numérisés placés dans la mémoire tampon circulaire (320) en réponse au signal déclencheur ;
l'instrument d'essai et de mesure (300) étant **caractérisé par le fait qu'**il possède en outre :
un processeur (345) configuré pour recevoir une copie des échantillons numérisés traités du détecteur d'événement déclencheur (305) et du seuil de déclenchement spécifié par l'utilisateur, de façon à produire un indicateur à facteur de mérite de déclencheur en temps réel (350) comprenant :
un premier marqueur (455) indiquant un facteur de mérite de déclencheur en temps réel calculé sur la base des échantillons numérisés traités, dans lequel le facteur de mérite de déclencheur en temps réel est un aspect quantifiable du signal soumis au test ; et
un deuxième marqueur (460) basé sur le seuil de déclenchement spécifié par l'utilisateur, indiquant un niveau que le facteur de mérite de déclencheur en temps réel doit dépasser pour que le détecteur d'événement déclencheur (305) détecte un événement déclencheur et produise un signal de déclenchement ; et
un dispositif d'affichage configuré de façon à afficher l'indicateur à facteur de mérite de déclencheur en temps réel (350) ;
dans lequel l'indicateur à facteur de mérite de déclencheur en temps réel (350) fournit une indication continue de la mesure dans laquelle le signal à l'essai est proche de satisfaire le seuil de déclenchement spécifié par l'utilisateur sans que le déclenchement par l'instrument ne soit nécessaire.

2. Un instrument d'essai et de mesure (300) selon la revendication 1, dans lequel l'indicateur à facteur de mérite de déclencheur en temps réel (350) comprend également un troisième marqueur (465) indiquant un état de détecteur d'événement déclencheur (305).

3. Un instrument d'essai et de mesure (300) selon la revendication 1, dans lequel le détecteur d'événement déclencheur (305) est sélectionné dans le groupe composé d'un déclencheur de niveau de puissance, d'un déclencheur de niveau de puissance filtré, d'un déclencheur à masque de fréquence, d'un déclencheur de densité, d'un déclencheur de domaine de modulation, d'un déclencheur extérieur, d'un déclencheur à schémas de données, et d'un déclencheur de signature spectrale.

4. Un instrument d'essai et de mesure (300) selon la revendication 1, dans lequel l'instrument d'essai et de mesure est un instrument d'essai et de mesure sélectionné dans un groupe composé d'un analyseur de spectre, d'un oscilloscope, et d'un analyseur logique.

5. Un instrument d'essai et de mesure (300) selon la revendication 1, dans lequel l'indicateur à facteur de mérite de déclencheur en temps réel s'affiche sur le dispositif d'affichage (355) sélectionné dans un groupe composé d'un dispositif d'affichage et d'un panneau avant.

6. Un instrument d'essai et de mesure (300) selon la revendication 1, dans lequel l'indicateur à facteur de mérite de déclencheur en temps réel est un quelconque des suivants :
une puissance instantanée du signal soumis à l'essai ;
une puissance instantanée d'un signal filtré soumis à l'essai ;
une mesure de la qualité du signal, par exemple une magnitude d'erreur vectorielle (EVM), une magnitude d'erreur, un déséquilibre en phase / quadrature (I/Q), une asymétrie, un décalage de l'origine, un nombre de bits par seconde, ou de paquets par seconde.
